# FASCICULE DE BREVET EUROPEEN

(11) **EP 0 341 177 B1**
(45) Date de publication et mention de la délivrance du brevet: **29.09.1993**
(21) Numéro de dépôt: 89440040.7
(22) Date de dépôt: 03.05.1989
(51) Int. Cl.: G05D 23/275, H05B 3/56

(54) **Module de régulation pour traceur électrique**
Regelungsmodul für eine Rohrheizung
Regulation module for electric tracing means

(30) Priorité: 05.05.1988 FR 8806255
(43) Date de publication de la demande: 08.11.1989
(73) Titulaire: Belanger, Bernard, F-68100 Mulhouse (FR)
(72) Inventeur: Belanger, Bernard, F-68100 Mulhouse (FR)
(74) Mandataire: Nuss, Pierre

(56) Documents cités:
- WO-A-83/01138
- AU-B- 552 081
- US-A- 4 575 617
- 33RD ANNUAL PETROLEUM AND CHEMICAL INDUSTRY CONFERENCE, Philadelphia, Pennsylvania, 8-10 septembre 1986, Record of Conference Papers, pages 15-19, IEEE, New York, NJ, US; B.C. JOHNSON et al.: "Power line carrier systems for electric heat tracing control and monitoring"

## Description

La présente invention concerne le domaine du traçage électrique de tuyaux ou de réservoirs et a pour objet un module de régulation our traceur électrique.

Le traçage électrique consiste à munir un tuyau ou un réservoir, transportant ou renfermant des matières devant être maintenue à une température ou dans une fourchette de température donnée, d'un ruban plat de faible épaisseur constitué par des conducteurs en cuivre dans lesquels circule généralement un courant de 220 volts, ces conducteurs étant séparés par une matière semi-conductrice produisant un dégagement de chaleur, l'ensemble étant recouvert d'au moins une gaine d'isolation. Les traceurs sont posés linéairement ou en spirale sur des tuyaux, des cuves de réservoir, des trémis, des vannes ou sur d'autres matériels devant être tracés.

En fonction de la nature du semi-conducteur utilisé, la puissance de chauffage au mètre linéaire varie. Cette puissance est généralement déterminée par les fournisseurs des rubans traceurs en tenant compte de la température ambiante, de la nature du contenant, de la longueur de ruban à poser, du calorifugeage et de la température souhaitée.

Il existe deux types d'installations de traçage, à savoir celles de traçage hors gel et celles de maintien en température.

Les installations de traçage hors gel comportent, en général, un thermostat d'ambiance ou de régulation placé dans un endroit défavorable, qui met en service le traceur quand une température prédéterminée est atteinte. Une telle installations est notamment utilisée pour la protection de conduites d'eau.

Les installations de traçage pour le maintien en température sont utilisées pour maintenir certaines matières à une température prédéterminée. A titre d'exemple, en considérant un produit cristallisant à 30°C, sa température devra être maintenue à environ 40°C afin d'éviter une obstruction éventuelle de conduites. A cet effet, on utilise généralement deux thermostats dont l'un met en et hors service le ruban traceur et qui est réglé à la température et dont l'autre, qui est réglé à une température comprise entre la température de cristallisation et la température de maintien, enclenche une alarme sonore ou visuelle dans le cas d'un fonctionnement défectueux du premier thermostat.

La commande des installations de traçage s'effectue au moyen d'un ensemble électrique comprenant une partie puissance et une partie de régulation.

La partie puissance est constituée par un dijoncteur bipolaire de protection, par un dijoncteur différentiel de sécurité, par un contacteur de mise en service, par un temporisateur de mise en service du contacteur et par deux porte-fusibles de protection de la commande et de la signalisation

La partie de régulation comporte généralement des relais de mise en service et/ou hors service du traceur et de l'alarme sonore et/ou visuelle. Ces relais sont montés sur un barreau au moyen d'accessoires de fixation et sont raccordés par l' intermédiaire de fils munis d'embouts à des bagues de connexion numérotées, ainsi qu à des voyants témoins de fonctionnement montés sur une porte d'armoire de commande ensemble avec les boutons et commutateurs.

La réalisation de la partie de régulation nécessite un temps de montage relativement important du fait des divers traçages, perçages et connexions à effectuer.

La présente invention a pour but de pallier les inconvénients de la partie de régulation des installations de traçage connues.

Elle a, en effet, pour objet un module de régulation pour traceur électrique caractérisé en ce qu'il est essentiellement constitué par une plaque, formant un circuit imprimé, sur laquelle sont montés un relais de thermostat bas enregistrant une information d'alarme issue d'un thermostat de détection de température minimale de fonctionnement, un relais de thermostat haut de mise en ou hors service d'un ruban traceur, un relais de défaut de traceur actionné en cas de détection d'une discontinuité ou d'un défaut d'isolement du ruban traceur, un relais de défaut général regroupant les informations issues des relais de thermostat bas et/ou de défaut de traceur, un relais de continuité du traceur controlant la continuité des conducteurs du traceur, un relais contacteur auxiliaire fonctionnant simultanément avec le relais de thermostat haut, ainsi qu'un commutateur à trois positions fixes, à savoir d'arrêt, de fonctionnement automatique commandé par le thermostat de régulation de l'installation et de fonctionnement manuel correspondant à une marche forcée, par un ensemble de signalisation des états de fonctionnement des organes de commande muni de voyants disposés sur une plaquette de face avant s'étendant perpendiculairement à la plaque constituant le circuit imprimé et reliée à cette dernière et par un connecteur d'embrochage de la plaque constituant le circuit imprimé.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
la figure 1 est un schéma électrique du module conforme à l'invention ;
la figure 2 est une vue en élévation latérale du module suivant la figure 1, et
la figure 3 est un schéma électrique du circuit de signalisation.

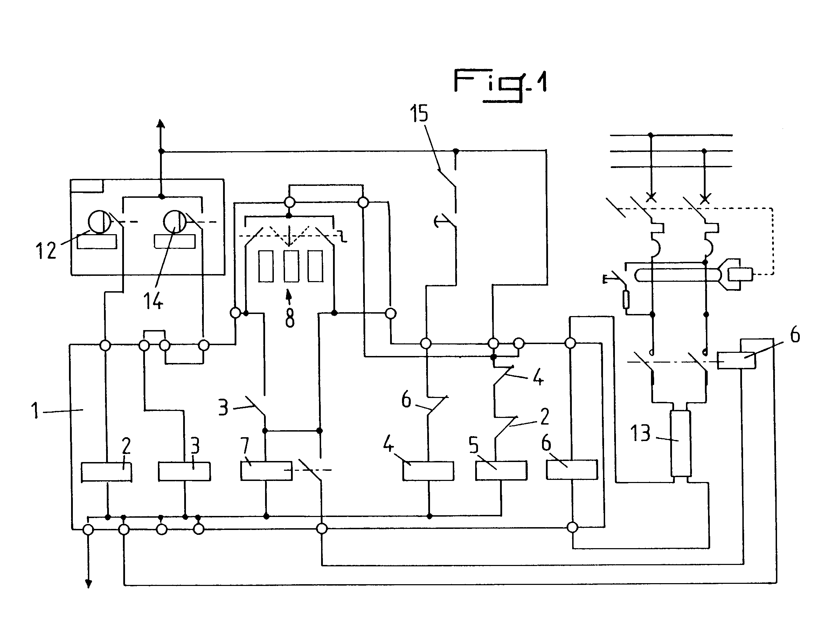

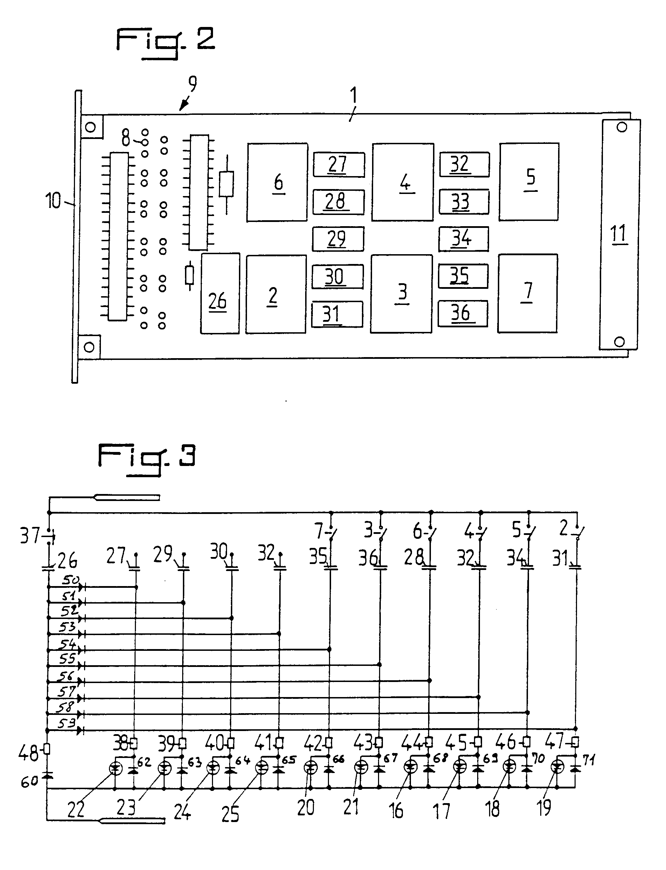

Conformément à l'invention et comme le montrent plus particulièrement les figures 1 et 2 des dessins annexés, le module de régulation pour traceur électrique est essentiellement constitué par une plaque 1, formant un circuit imprimé, sur laquelle sont montés un relais de thermostat bas 2, un relais de thermostat haut 3, un relais de défaut de traceur 4, un relais de défaut général 5, un relais de continuité du traceur 6, un relais contacteur auxiliaire 7, ainsi qu'un commutateur 8 à trois positions fixes, par un ensemble 9 de signalisation des états de fonctionnement des organes de commande muni de voyants disposés sur une plaquette de face avant 10 s'étendant perpendiculairèment à la plaque 1 constituant le circuit imprimé et reliée à cette dernière et par un connecteur 11 d'embrochage de la plaque 1 constituant le circuit imprimé.

Le relais de thermostat bas 2 est destiné à l'enregistrement d'une information d'alarme délivrée par un thermostat 12 de détection de température minimale de fonctionnement, c'est-à-dire de la température minimale devant être délivrée par le traceur pour maintenir la conduite, le réservoir, ou autres, ainsi équipé à une température hors gel ou à une température minimale d'utilisation.

Le relais de thermostat haut 3 sert à la mise en ou hors service du ruban traceur 13 après mise sous tension au moyen du thermostat de régulation 14. La position fermée du relais 3 correspond à la marche normale.

Le relais de défaut de traceur 4 est actionné lorsque le ruban traceur 13 présente une discontinuité ou un défaut d'isolement et coupe l'alimentation du contacteur de puissance 15.

Le relais de défaut général 5 regroupe les informations qui sont issues des relais de thermostat bas 2 et/ou de défaut de traceur 4. Ce relais permet, par exemple, de renvoyer dans une salle de contrôle le signal de mauvais fonctionnement du traceur 13 par simple branchement d'une ligne électrique sur la broche de connexion correspondante du connecteur 11.

Le relais de continuité du traceur 6 contrôle la continuité des conducteurs du traceur 13. Ce contrôle est effectué par application de deux phases à 220 volts à une extrémité desdits conducteurs et par vérification de la tension à l'autre extrémité de ces phases. Ce relais 6 est, en marche normale, actionné dès la mise en service du module.

Le relais contacteur auxiliaire 7 fonctionne simultanément avec le relais de thermostat haut 3 et un de ses contacts actionne le contacteur de puissance 15.

Le commutateur 8 est un commutateur à trois positions fixes permettant, en position centrale, l'arrêt du fonctionnement, dans une position automatique la marche commandée par le thermostat de régulation 14 et dans une position manuelle une marche forcée décidée par l'utilisateur.

Le module conforme à l'invention est avantageusement disposé dans une armoire électrique à la manière d'un tiroir embrochable la porte de l'armoire étant avantageusement équipée d'une fenêtre et éventuellement d'un commutateur raccordé au commutateur 8 pour la réalisation d'une commande externe.

L'ensemble 9 de signalisation des états de fonctionnement des organes de commande est constitué, d'une part, par des voyants 16 à 21 sous forme de diodes électroluminescentes disposées sur la plaquette de face avant 10 signalant l'état des relais 2 à 7 et, d'autre part, par des voyants 22 à 25, respectivement de signalisation du fonctionnement du ruban traceur 13, de l'atteinte de la température prédéterminée par réglage du thermostat de régulation 14, d'atteinte de la température d'alarme et de signalisation d'une discontinuité du ruban traceur 13 ou d'un déclenchement de la partie puissance, ces voyants 16 à 25 étant reliés aux circuits et organes correspondants par l'intermédiaire de condensateurs 26 à 36 et de résistances 38 à 48, ainsi que de diodes 50 à 71, l'état de fonctionnement des voyants étant vérifié au moyen d'un bouton d'essai 37 pouvant éventuellement être doublé par un deuxième bouton disposé sur la porte de l'armoire.

Les voyants 16 à 21 qui signalent l'état de fonctionnement des relais 2 à 7 sont uniquement destinés à signaler un circuit défectueux en vue de permettre un dépannage rapide.

Les condensateurs 27 à 36 sont insérés dans le circuit d'alimentation du ruban traceur 13, ensemble avec les résistances 38 à 47, afin de permettre une alimentation directe des diodes 6 à 25 et le condensateur 26 et la résistance 48, qui présentent respectivement une capacité égale à celle totale des condensateurs 27 à 36 et une résistance inversement proportionnelle à celle totale des résistances 38 à 47, sont également insérés dans le circuit d'alimentation du ruban traceur 13 afin de permettre l'alimentation des voyants 16 à 25 simultanément lors de l'essai lampe a moyen du bouton 37.

Les diodes 50 à 59 sont uniquement utilisées pour le circuit essai lampes et permettent cet essai au moyen du seul bouton 37. En outre, ces diodes interdisent un retour de courant lors de la marche normale.

La diode 60 et les diodes 62 à 71 sont destinées à autoriser la décharge du condensateur 26 lors de la deuxième alternance du courant.

Enfin, le connecteur 11 permet les entrées et sorties de toutes les informations du module conforme à l'invention, par exemple en provenance et en direction d'une salle de contrôle.

Grâce à l'invention, il est possible de réaliser un module de régulation pour traceur électrique de constitution simple et de faible prix de revient.

En outre, ce module est très compact et permet un gain de place important par rapport aux circuits de régulation existant actuellement et le coût de main d'oeuvre à l'installation de ce module est très nettement réduit par rapport auxdits circuits existants.

## Revendications

1. Module de régulation pour traceur électrique étant constitué par une plaque (1), formant un circuit imprimé, sur laquelle sont montés un relais de thermostat bas (2) enregistrant une information d'alarme issue d'un thermostat (12) de détection de température minimale de fonctionnement, un relais de thermostat haut (3) de mise en ou hors service d'un ruban traceur (13), un relais de défaut de traceur (4) actionné en cas de détection d'une discontinuité ou d'un défaut d'isolement du ruban traceur (13), caractérisé en ce que la plaque (1) comprend en plus un relais de défaut général (5) regroupant les informations issues des relais de thermostat bas (2) et/ou de défaut de traceur (4), un relais de continuité du traceur (6) contrôlant la continuité des conducteurs du traceur (13), un relais contacteur auxiliaire (7) fonctionnant simultanément avec le relais de thermostat haut (3), ainsi qu'un commutateur à trois positions fixes (8), à savoir d'arrêt, de fonctionnement automatique commandé par le thermostat de régulation (14) de l'installation et de fonctionnement manuel correspondant à une marche forcée, et en un ensemble (9) de signalisation des états de fonctionnement des organes de commande muni de voyants disposés sur une plaquette de face avant (10) s'étendant perpendiculairement à la plaque (1) constituant le circuit imprimé et reliée à cette dernière et par un connecteur (11) d'embrochage de la plaque (1) constituant le circuit imprimé.

2. Module, suivant la revendication 1, caractérisé en ce qu'il est avantageusement disposé dans une armoire électrique à la manière d'un tiroir embrochable, la porte de l'armoire étant avantageusement équipée d'une fenêtre et éventuellement d'un commutateur raccordé au commutateur (8) pour la réalisation d'une commande externe.

3. Module, suivant la revendication 1, caractérisé en ce que l'ensemble (9) de signalisation des états de fonctionnement des organes de commande est constitué, d'une part, par des voyants (16 à 21) sous forme de diodes électroluminescentes disposées sur la plaquette de face avant (10) signalant l'état des relais (2 à 7) et, d'autre part, par des voyants (22 à 25), respectivement de signalisation du fonctionnement du ruban traceur (13), de l'atteinte de la température prédéterminée par réglage du thermostat de régulation (14), d'atteinte de la température d'alarme et de signalisation d'une discontinuité du ruban traceur (13) ou d'un déclenchement de la partie puissance, ces voyants (16 à 25) étant reliés aux circuits et organes correspondants par l'intermédiaire de condensateurs (26 à 36) et de résistances (38 à 48), ainsi que de diodes (50 à 71), l'état de fonctionnement des voyants étant vérifié au moyen d'un bouton d'essai (37) pouvant éventuellement être doublé par un deuxième bouton disposé sur la porte de l'armoire.

4. Module, suivant la revendication 1, caractérisé en ce que les condensateurs (27 à 36) sont insérés dans le circuit d'alimentation du ruban traceur (13), ensemble avec les résistances (38 à 47), afin de permettre une alimentation directe des diodes (16 à 25) et le condensateur (26) et la résistance (48), qui présentent respectivement une capacité égale à celle totale des condensateurs (27 à 36) et une résistance inversement proportionnelle à celle totale des résistances (38 à 47), sont également insérés dans le circuit d'alimentation du ruban traceur (13) afin de permettre l'alimentation des voyants (16 à 25) simultanément lors de l'essai lampe au moyen du bouton (37).

## Claims

1. Regulating module for an electric plotter consisting of a board (1) forming a printed circuit on which there are mounted a low level thermostat relay (2) recording alarm information issuing from a thermostat (12) for minimum operating temperature detection, a high level thermostat relay (3) for putting a plotting ribbon (13) into and out of operation, a plotter fault relay (4) actuated on detection of a break or an insulating defect in the plotting ribbon (13), characterised in that the board (1) also comprises a general fault relay (5) collecting the information issuing from the low level thermostat relay (2) and/or plotter fault relay (4), a plotter continuity relay (6) monitoring the continuity of the conductors of the plotter (13), an auxiliary contacting relay (7) operating simultaneously with the high level thermostat relay (3) as well as a selector switch having three fixed positions (8), that is a stop position, an automatic operating position controlled by the regulating thermostat (14) of the installation and a manual operating position corresponding to a forced run, a unit (9) for signalling the states of operation of the control members equipped with indicators arranged on a front face plate (10) extending perpendicularly to the board (1) constituting the printed circuit and connected to the board (1) and a connector (11) for plugging in the board (1) constituting the printed circuit.

2. Module according to Claim 1, characterised in that it is advantageously arranged in an electric switch cabinet in the manner of a plug-in drawer, the door of the cabinet advantageously being equipped with a window and optionally with a selector switch connected to the selector switch (8) for effecting external control.

3. Module according to Claim 1, characterised in that the unit (9) for signalling the states of operation of the control members consists, on the one hand, of indicators (16 to 21) in the form of light-emitting diodes arranged on the front face plate (10) signalling the state of the relays (2 to 7) and, on the other hand, of indicators (22 to 25) respectively signalling the operation of the plotting ribbon (13), the attainment of the predetermined temperature by adjustment of the regulating thermostat (14), attainment of the alarm temperature and signalling of a break in the plotting ribbon (13) or of triggering of the power element, these indicators (16 to 25) being connected to the corresponding circuits and members by means of capacitors (26 to 36) and resistors (38 to 48) and by diodes (50 to 71), the operating state of the indicators being checked by means of a test button (37) which may optionally be doubled by a second button arranged on the door of the cabinet.

4. Module according to Claim 1, characterised in that the capacitors (27 to 36) are inserted in the supply circuit of the plotting ribbon (13) together with the resistors (38 to 47) to allow direct supply of the diodes (16 to 25) and the capacitor (26) and the resistor (48), which have respectively capacitance equal to the total capacitance of the capacitors (27 to 36) and resistance inversely proportional to the total resistance of the resistors (38 to 47), are also inserted into the supply circuit of the plotting ribbon (13) to allow the supply of the indicators (16 to 25) simultaneously during the lamp test by means of the button (37).

## Patentansprüche

1. Regelungsmodul für eine elektrische Begleitheizung, mit einer eine gedruckte Schaltung bildenden Platine (1), auf welcher angeordnet sind: ein einem unteren Temperaturgrenzwert zugeordnetes Thermostatrelais (2), welches eine Alarminformation registriert, die von einem Thermostaten (12) abgegeben wird, der auf das Vorliegen einer minimalen Arbeitstemperatur anspricht, ein einem oberen Temperaturgrenzwert zugeordnetes Thermostatrelais (3), durch welches ein Begleitheizband (13) ein- und ausgeschaltet wird, und ein Heizband-Fehlerrelais (4), das betätigt wird, wenn eine Unterbrechung des Begleitheizbandes (13) oder ein Fehler in der Isolierung des Begleitheizbandes (13) vorliegt, dadurch gekennzeichnet, daß die Platine (1) zusätzlich aufweist: ein globales Fehlerrelais (5), welches die Informationen zusammenfaßt, welche von dem dem unteren Temperaturgrenzwert zugeordneten Thermostatrelais (2) und/oder dem Heizband-Fehlerrelais (4) bereitgestellt werden; ein Heizband-Durchgangsrelais (6), welches den Durchgang der Leiter des Begleitheizbandes überwacht; ein Hilfskontaktrelais (7), welches gleichzeitig mit dem dem oberen Temperaturgrenzwert zugeordneten Relais (3) arbeitet; einen Schalter (8) mit drei Arbeitsstellungen, nämlich einer Arbeitsstellung "Halt", einer Arbeitsstellung "Automatischer Betrieb", in welcher eine Steuerung durch den Regelthermostat (14) der Anlage erfolgt, und eine Arbeitsstellung "manueller Betrieb", in welcher ein Arbeiten zwangsweise herbeigeführt wird; und eine Meldeeinheit (9), welche die Betriebszustände der Steuermittel meldet und mit Sichtanzeigen versehen ist, die auf einer vorderen Stirnplatte (10) angeordnet sind, welche sich in zur die gedruckte Schaltung bildenden Platine (1) senkrechter Richtung erstreckt und mit dieser durch einen Steckverbinder (11) der die gedruckte Schaltung bildenden Platine (1) verbunden ist.

2. Regelungsmodul nach Anspruch 1, dadurch gekennzeichnet, daß er vorzugsweise in einem Steuerschrank nach Art eines steckbaren Einschubes angeordnet ist, wobei die Tür des Schrankes vorzugsweise mit einem Fenster ausgebildet ist und gegebenenfalls mit einem Schalter versehen ist, der mit dem drei Arbeitsstellungen aufweisenden Schalter (8) verbunden ist, um eine externe Betätigung zu ermöglichen.

3. Regelungsmodul nach Anspruch 1, dadurch gekennzeichnet, daß die Meldeeinheit (9), welche die Betriebszustände der Steuermittel meldet, einerseits Sichtanzeigen (16 bis 21) für den Betriebszustand der Relais (2 bis 7) in Form von lichtemittierenden Dioden aufweist, die auf der vorderen Stirnplatte (10) angeordnet sind, und andererseits Sichtanzeigen (22 bis 25) umfaßt, welche das Arbeiten des Begleitheizbandes (13), das Erreichen der durch Einstellung des Regelthermostaten (14) vorgegebenen Temperatur, das Erreichen der Alarmtemperatur und das Vorliegen einer Unterbrechung des Begleitheizbandes (13) oder ein Auslösen des Leistungsteiles signalisieren, wobei die Sichtanzeigen (16 bis 25) mit entsprechenden Schaltkreisen und entsprechenden Organen über Kondensatoren (26 bis 36) und Widerstände (38 bis 48) sowie Dioden (50 bis 71) verbunden sind, und wobei das Arbeiten der Sichtanzeigen unter Verwendung eines Testknopfes (37) überprüft wird, der gegebenenfalls durch einen zweiten Knopf verdoppelt sein kann, der auf der Schranktür angeordnet ist.

4. Regelungsmodul nach Anspruch 1, dadurch gekennzeichnet, daß die Kondensatoren (27 bis 36) in den Speisekreis des Begleitheizbandes (13) zusammen mit den Widerständen (38 bis 47) eingefügt sind, damit man eine direkte Versorgung der Dioden (16 bis 25) sowie des Kondensators (26) und des Widerstandes (48) erhält wobei die letztgenannten Bauelemente eine Kapazität haben, die gleich der Gesamtkapazität der Kondensatoren (27 bis 36) ist, bzw. einen Widerstand haben, der umgekehrt porportional zum Gesamtwiderstand der Widerstände (38 bis 47) ist, wobei diese Teile gleichermaßen in den Speisekreis des Begleitheizbandes (13) eingefügt sind, damit man gleichzeitig mit der Lampenprüfung mittels des Knopfes (37) eine Speisung der Sichtanzeigen (16 bis 25) erhält.
